# EUROPÄISCHE PATENTSCHRIFT

(11) **EP 2 235 811 B1**
(45) Veröffentlichungstag und Bekanntmachung des Hinweises auf die Patenterteilung: **05.04.2017**
(21) Anmeldenummer: 08871509.9
(22) Anmeldetag: 17.11.2008
(51) Int. Cl.: H02K 5/10, H05K 5/02

(54) **GERÄT UND VERFAHREN ZUR HERSTELLUNG EINES GERÄTS**
DEVICE AND METHOD FOR THE PRODUCTION OF A DEVICE
APPAREIL ET SON PROCÉDÉ DE FABRICATION

(30) Priorität: 21.01.2008 DE 102008005395
(43) Veröffentlichungstag der Anmeldung: 06.10.2010
(73) Patentinhaber: SEW-EURODRIVE GmbH & Co. KG, 76646 Bruchsal (DE)
(72) Erfinder: DAMINGER, Franz, 76694 Forst (DE)
(86) Internationale Anmeldenummer: PCT/EP2008/009708
(87) Internationale Veröffentlichungsnummer: WO 2009/092412

(56) Entgegenhaltungen:
- EP-A- 0 510 645
- EP-A- 0 831 572
- WO-A-2006/120707
- WO-A-2007/076976
- US-A- 4 739 458
- US-A- 4 978 875

## Beschreibung

Die Erfindung betrifft ein Gerät und ein Verfahren zur Herstellung eines Geräts. In der US 4 978 875 A ist ein Drainage-Stopfen für ein Gerät gezeigt, wobei der Stopfen in einer Ausnehmung der Gehäusewand des Geräts angeordnet ist.

Aus der US 4 739 458 A ist ein von außen auf eine Luftöffnung aufgestecktes Schlauchstück bekannt.

Aus der WO 2006/120707 A ist eine röhrenförmige Entlüftungseinrichtung bekannt.

Aus der WO 2007/076976 A1 ist eine semipermeable Membran bekannt zur Entlüftung eines Geräts.

Der Erfindung liegt daher die Aufgabe zugrunde, ein Gerät verbessert zu entlüften.

Erfindungsgemäß wird die Aufgabe bei dem Gerät nach den in Anspruch 1 und bei dem Verfahren nach den in Anspruch 18 angegebenen Merkmalen gelöst.

Wichtige Merkmale der Erfindung bei dem Gerät sind, dass in einer Ausnehmung eines Gehäuseteils des Geräts, insbesondere in einer Ausnehmung in der Gehäusewand des Geräts, ein Schlauch vorgesehen ist, insbesondere ein Entlüftungsschlauch,
wobei der Schlauch ein aus dem Gehäuse des Geräts herausragendes Schlauchteil umfasst.

Von Vorteil ist dabei, dass das Schlauchteil herausragt und somit von der Gravitationskraft und seinem Eigengewicht ausgelenkt wird in Richtung der Gravitation. Somit ist es für Flüssigkeiten wie Wasser oder Reinigungsflüssigkeiten nur schwer möglich, durch den Schlauch ins Geräteinnere vorzudringen. Bei Spritzwasser, das beispielsweise bei Reinigungstätigkeiten in einer Richtung im Schlauchbereich aufgebracht wird, wird der herausragende Schlauchteil ausgelenkt und somit das Eindringen von Wasser in das Schlauchinnere und Geräteinnere verhindert.

Ein weiterer Vorteil besteht darin, dass sich vor einer im zum Innenraum des Geräts gerichteten Endbereich des Schlauchs vorgesehenen Membran kein Wasser ansammeln kann, das die Membran verstopfen könnte. Denn das Wasser wird durch den Schlauch nach unten herausgeleitet.

Bei einer vorteilhaften Ausgestaltung ist das aus dem Gehäuse des Geräts herausragende Schlauchteil aus einem derart elastischen Werkstoff ausgeführt, dass der herausragende Endbereich des Schlauchteils in Gravitationsrichtung ausrichtbar ist vom Eigengewicht des Schlauchteils, insbesondere von der Eigengewichtskraft des Schlauchteils, im Gravitationsfeld der Erde. Von Vorteil ist dabei, dass das Schlauchende somit nach unten weist und somit das Eindringen von Wasser noch besser verhindert ist als bei einer Schräglage des Schlauchs.

Insbesondere ist das aus dem Gehäuse des Geräts herausragende Schlauchteil aus einem derart elastischen Werkstoff ausgeführt und derart lang vorgesehen, dass der herausragende Endbereich des Schlauchteils in Gravitationsrichtung weist, insbesondere bei Ausbleiben weiterer wesentlicher Krafteinwirkungen oder Kräfte.

Bei einer vorteilhaften Ausgestaltung ist der Schlauch aus einem derart elastischen Material vorgesehen und umfasst ein derart lang aus dem Gerät herausragendes Schlauchteil, dass der herausragende Endbereich des Schlauchteils in Gravitationsrichtung weist, insbesondere bei Fernbleiben sonstiger Krafteinwirkungen, oder bei einwirkenden Kräften, insbesondere verursacht durch beispielsweise Spritzwasser, Luftstrom oder dergleichen, auslenkbar ist und/oder eine Auslenkung erfährt, insbesondere in Richtung der Krafteinwirkung. Von Vorteil ist dabei, dass auch bei Spritzwassereinwirkung ein Eindringen von Wasser verhindert ist.

Bei einer vorteilhaften Ausgestaltung ist in dem ins Geräteinnere weisenden Endbereich des Schlauchs und/oder anschließend an das ins Geräteinnere weisende Ende des Schlauchs eine Membran vorgesehen. Von Vorteil ist dabei, dass zwar ein Luftdruckausgleich bewirkbar ist durch die Membran hindurch, jedoch Wasser oder Wasserdampf nicht eindringen kann ins Geräteinnere.

Bei einer vorteilhaften Ausgestaltung ist zwischen dem Schlauch und dem Innenraum des Geräts eine Membran vorgesehen. Insbesondere ist die Membran als semipermeable Membran vorgesehen. Von Vorteil ist dabei, dass Wasser und/oder Wasserdampf nicht eindringen kann oder zumindest in nur geringem Umfang und Luft aber sehr wohl in beiden Richtungen durch die Membran gelassen wird. Somit ist ein Luftdruck, der beispielsweise infolge Erwärmung oder Abkühlung der Elektronik oder Spulenwicklungen entsteht, schnell ausgleichbar.

Bei einer vorteilhaften Ausgestaltung ist zwischen Schlauchteil und Membran ein Prallschutz vorgesehen, insbesondere ein am Schlauch einstückig ausgebildeter. Von Vorteil ist dabei, dass die Membran geschützt anordenbar ist, insbesondere vor Wasser, das unter Druck in den Schlauch eingespritzt wird.

Bei einer vorteilhaften Ausgestaltung ist an dem zum Innenraum des Geräts gerichteten Endbereich des Schlauchs ein Prallschutz einstückig ausgebildet oder separat vorgesehen und verbunden. Von Vorteil ist dabei, dass Fertigung des Prallschutzes einstückig mit dem Schlauch und daher einfach und kostengünstig ausführbar ist.

Bei einer vorteilhaften Ausgestaltung ist der Schlauch in der Ausnehmung des Geräts formschlüssig gehalten. Von Vorteil ist dabei, dass eine sichere und auch dichte Verbindung herstellbar ist in einfacher Weise.

Bei einer vorteilhaften Ausgestaltung weist die Schlauchwand Verdickungen auf zum formschlüssigen Halten des Schlauchs in der Ausnehmung des Geräts. Von Vorteil ist dabei, dass die Verdickungen gleichzeitig als Abdichtung vorsehbar sind. Außerdem muss das Gehäuseteil in den die Verdickungen berührenden Bereichen des Gehäuseteils nicht fein bearbeitet werden sondern es genügt, diese Bereiche als unbearbeitete Gussteilbereiche zu belassen. Die Verdickungen sind aus dem elastischen Material des Schlauchs ausgeführt und dichten somit auch bei rauer Oberfläche gut. Insbesondere ist es dabei vorteilhaft, bei der Herstellung des Schlauchs den Abstand zwischen den Verdickungen kleiner vorzusehen als die Gehäusewandstärke im Bereich der Ausnehmung. Auf diese Weise entsteht eine elastische Zugspannung, die die Verdickungen auf die berührenden Bereiche des Gehäuseteils drückt und somit die Dichtigkeit weiter verbessert.

Bei einer vorteilhaften Ausgestaltung ist die Membran mit einem Haltemittel, insbesondere Ring, verbunden. Von Vorteil ist dabei, dass der Ring einfach und schnell befestigbar ist in einer Verdickung des Schlauchteils oder in dem Gehäuseteil.

Bei einer vorteilhaften Ausgestaltung ist das Haltemittel mit dem Gehäuseteil verbunden oder das Haltemittel mit dem Schlauch verbunden, insbesondere auf der vom Schlauchteil abgewandten Seite des Prallschutzes. Von Vorteil ist dabei, dass das Haltemittel schnell und einfach verbindbar ist.

Bei einer vorteilhaften Ausgestaltung ist der Prallschutz über Haltesäulen am Schlauch gehalten, zwischen denen in radialer Richtung durchströmbare Ausnehmungen vorgesehen sind. Von Vorteil ist dabei, dass in den Schlauch eingespritztes Wasser eine Richtungsänderung ausführen muss und in ein vergrößertes Volumen einströmen muss, wodurch die Geschwindigkeit und der Druck abnimmt und somit die Membran schützbar ist.

Bei einer vorteilhaften Ausgestaltung umfasst das Gehäuseteil eine gestufte Flachsenkung, die um die als Durchgangsbohrung ausgeführte Ausnehmung herum vorgesehen ist, insbesondere zur Aufnahme des Haltemittels für die Membran und für eine den Prallschutz aufnehmende Verdickung des Schlauchs. Von Vorteil ist dabei, dass eine bearbeitete Fläche zur Verfügung gestellt ist und der in den Innenraum weisende Endbereich des Schlauchs schützbar ist mit dem stabilen Material des Gehäuseteils, beispielsweise Stahl oder Aluminium.

Bei einer vorteilhaften Ausgestaltung ist eine erste der Verdickungen kegelförmig ausgeführt. Von Vorteil ist dabei, dass der Schlauch in einer ersten Richtung leicht und schnell durch die Ausnehmung einschiebbar und die erste der Verdickungen auch durchschiebbar ist.

Bei einer vorteilhaften Ausgestaltung ist eine zweite der Verdickungen derart ausgeführt, dass der Prallschutz von ihr umgeben ist und das Haltemittel für die Membran verbindbar ist. Von Vorteil ist dabei, dass der Prallschutz und das Haltemittel mit Membran von dieser Verdickung schützbar ist. Außerdem genügt eine einfache Bohrung als Ausnehmung im Gehäuseteil. Es ist also keine gestufte Flachsenkung oder dergleichen erforderlich.

Bei einer vorteilhaften Ausgestaltung umfasst das Gerät einen Elektronikraumbereich, einen Raumbereich für einen aus dem Elektronikbereich versorgten Elektromotor und einen Raumbereich für ein vom Elektromotor angetriebenes, Schmierstoff, wie Schmieröl, Schmierfett oder dergleichen, umfassendes Getriebe,
wobei der Schlauch zur Entlüftung des Elektronikraumbereichs vorgesehen ist,
wobei zwischen Elektronikraumbereich und Raumbereich für Elektromotor eine Öffnung vorgesehen ist,
wobei zwischen Raumbereich für Elektromotor und Raumbereich für Getriebe eine schmierstoffundurchlässige elastische Membran vorgesehen ist, die zum Druckausgleich zwischen Raumbereich für Elektromotor und Raumbereich für Getriebe verformbar ist in den Raumbereich des Elektromotors hinein.

Von Vorteil ist dabei, dass das Getriebe zum Motorraumbereich innenentlüftet ist und somit ein Druckausgleich in sehr kompakter Weise ermöglicht ist, indem das zum Druckausgleich notwendige Volumen im Grenzbereich zwischen Motor und Getriebe, die von einem gemeinsamen Gehäuse umgeben sind, ermöglicht ist. Der somit oder unabhängig davon entstehende Druckunterschied zwischen Motorbereich und Elektronikbereich wird durch eine Öffnung, beispielsweise im Bereich der Kabeldurchführung vorgesehen. Der Elektronikbereich ist über den Schlauch nach außen entlüftet. Alle Raumbereiche sind von einem gemeinsamen Gehäuse des Geräts umgeben. Der Elektronikbereich umfasst vorzugsweise einen den Elektromotor versorgenden Frequenzumrichter, wodurch die Erwärmungsverläufe des Elektronikbereichs und Motorbereichs verschieden sind und somit auch schon zwischen diesen beiden Bereichen Luftdruckunterschiede entstehen.

Weitere Vorteile ergeben sich aus den Unteransprüchen.

### Bezugszeichenliste

- 1: Schlauch
- 2: Gehäuseteil
- 3: Verdickung
- 4: Gehäusedeckel
- 5: Ring
- 6: Membran
- 7: Prallschutz
- 8: Tragesäulen
- 9: Verdickung
- 10: kastenförmiger Endbereich
- 51: Raumbereich für Elektronik
- 52: Raumbereich für Elektromotor
- 53: Raumbereich für Getriebe
- 54: Membran
- 55: Öffnung

Die Erfindung wird nun anhand von Abbildungen näher erläutert:
In der Figur 1 ist ein erfindungsgemäßes Elektrogerät gezeigt, wobei ein Schlauch zur Entlüftung in Gravitationsrichtung aus dem Gerät heraushängt.

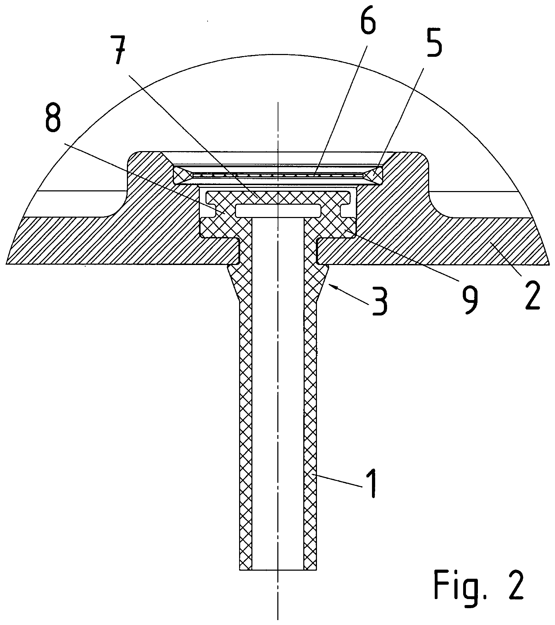

In Figur 2 ist ein vergrößerter Ausschnitt gezeigt.
In der Figur 3 ist dasselbe erfindungsgemäße Elektrogerät gezeigt, wobei die Orientierung des Geräts um 90° verdreht ist
In Figur 4 ist ein vergrößerter Ausschnitt gezeigt.
Figur 5 zeigt einen Ring 5 und die in seinem Inneren angebrachte Membran 6 in Schrägansicht separat.
In der Figur 6 ist ein anderes erfindungsgemäßes Ausführungsbeispiel gezeigt

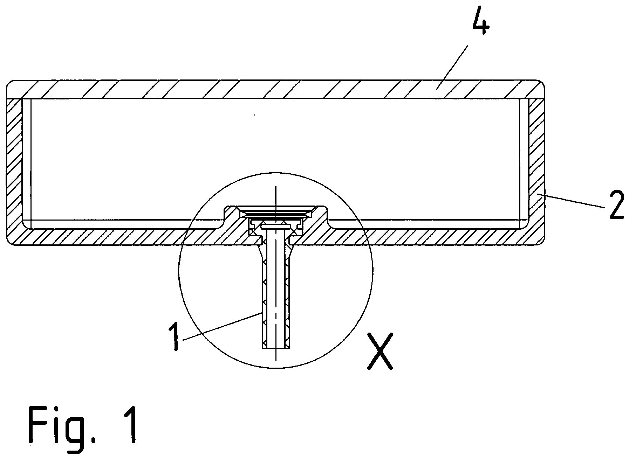

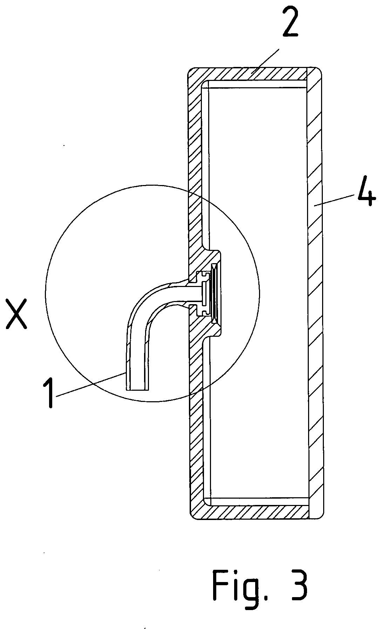

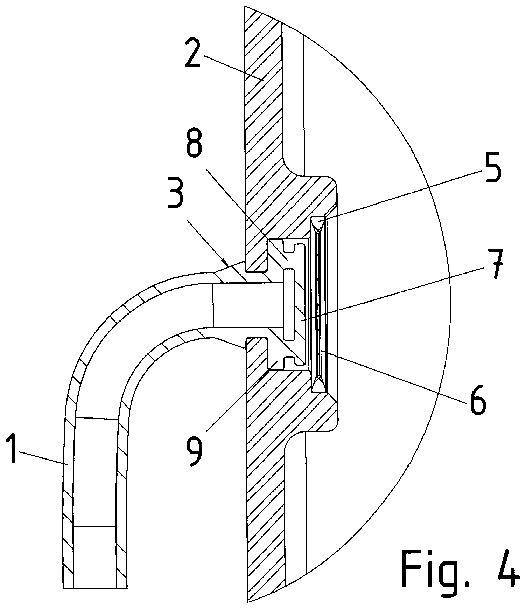

In der Figur 3 ist dasselbe wie in Figur 1 erfindungsgemäße Elektrogerät gezeigt, wobei die Orientierung des Geräts um 90° verdreht ist und somit der elastische und entsprechend lange Schlauch zur Entlüftung wiederum wegen seines geeignet vorgesehenen Eigengewichts, seiner geeignet vorgesehenen aus dem Gehäuseteil des Geräts herausragenden Länge und wegen seiner geeignet vorgesehenen Elastizität in Gravitationsrichtung aus dem Gerät heraushängt. In Figur 4 ist ein vergrößerter Ausschnitt gezeigt.

In den Figuren 1 und 3 ist gezeigt, dass der Schlauch 1 in einer Ausnehmung des Gehäuseteils 2 vorgesehen ist und mittels der Verdickung 3 und 9 formschlüssig in dieser Ausnehmung gehalten ist. Dabei ist der Schlauch 1 aus derart elastisch verformbarem Material ausgeführt, dass der Schlauch bei Fertigung des Geräts durch die Ausnehmung hindurchführbar ist, wobei die verdickten Bereiche derart komprimiert werden, dass der Schlauch durch die Ausnehmung hindurchführbar ist.

Am Endbereich des Schlauchs ist ein flächig ausgeformter Prallschutz 7 vorgesehen, der quer zur Schlauchrichtung eine den Schlauchdurchmesser überschreitende Ausdehnung aufweist und der mittels der Tragesäulen 8 an der Schlauchwand gehalten ist. Somit kann unter Druck eindringendes Wasser nur quer zur Schlauchrichtung, also quer zur Normalenrichtung der Prallschutzoberfläche, zwischen den Tragesäulen 8 hindurch ausweichen.

Auf diese Weise ist verhindert, dass unter Druck in den Schlauch eindringendes Wasser direkt auf eine in einem Ring 5 gehaltene Membran 6 trifft, wobei diese Membran auf der vom Schlauch 1 abgewandten Seite des Prallschutzes 7 vorgesehen ist, also zwischen dem Geräteinnenraum und dem Schlauch mit Prallschutz.

Vorzugsweise sind Schlauch 1, Verdickungen (3, 9) sowie Tragesäulen 8 und Prallschutz 7 einstückig ausgeführt.

Vorteiligerweise ist der Ring 5 in einer gestuft ausgeführten Sacklochbohrung vorgesehen, wobei in einer tiefer in die Gehäusewand eingebrachten Bohrungsbereich die Verdickung 9 anliegt an der Gehäusewand und somit eine dichte Verbindung zwischen Schlauch und Gehäusewand erreichbar ist. Hierzu ist auch eine durch elastische Auslenkung erzeugbare Druckkraft von Vorteil, die dadurch erzeugbar ist, dass die Verdickungen 3 und 9 im entspannten zustand einen geringeren Abstand in Schlauchrichtung zueinander aufweisen als im eingeführten Zustand vorgesehen ist, insbesondere also als die Restwandstärke beträgt.

Das Gehäuseteil 2 ist mittels eines Gehäusedeckels 4 abschließbar, insbesondere dicht.

Wenn nun die vom Gehäuse umfasste elektronische Schaltung oder die Statorwicklungen eines umfassten Elektromotors sich erwärmen, wird die Innenluft des Geräts erwärmt und somit ein Teil derselben nach außen gedrängt. Nach Abschalten oder einer Reduzierung der elektrischen Leistung der elektronischen Schaltung oder des Elektromotors kühlt die Luft im Innenraum des Geräts ab und Luft der Umgebung dringt langsam ein, beispielsweise durch undichte Stellen in der Abdichtung oder durch nicht absolut luftdichte Kabelverschraubungen. Auf diese Weise gelangt Feuchtigkeit ins Gerät. Mittels der erfindungsgemäßen Membran 6 wird dies verhindert, da diese semipermeabel ausgeführt ist und somit der Luftdruckunterschied schnell ausgleichbar ist, indem Luft durch die Membran 6 strömt, Wasser oder Wasserdampf jedoch nicht.

Darüber hinaus ist der Schlauch 1 aus einem derart elastischen Material, insbesondere ein Kunststoff, wie beispielsweise Elastomer, und ist derart lang und weit aus dem Gehäuseteil 2 heraushängend ausgeführt, dass schon das Eigengewicht des heraushängenden Schlauchteils dazu führt, dass der Schlauch 1 mit seinem heraushängenden Endbereich in Gravitationsrichtung zeigt, also kein Wasser einfließen kann. Insbesondere anstehendes Wasser kann somit nicht eindringen - zumindest bis zu einer kritischen Wasserstandshöhe. Hierzu ist in Figur 1 eine erste Einbaulage des Geräts in der Anlage und in Figur 3 eine zweite Einbaulage gezeigt, die 90° verdreht vorgesehen ist.

Zusätzlich ist durch die Elastizität des heraushängenden Schlauchteils ein Eindringen von Flüssigkeit bei Reinigungsarbeiten verhindert. Wenn nämlich Reinigungsflüssigkeit mit Druck in Richtung des Geräts vorgesehen wird, wird das herausstehende Schlauchteil in Spritzrichtung ausgelenkt und somit ist Eindringen von Flüssigkeit ins Gerät wiederum verhindert.

Das Material des Schlauchs ist vorzugsweise derart gewählt, dass beim Lackieren des Geräts kein Lack in den Schlauch eindringen kann. Dies ist beispielsweise dadurch bewirkbar, dass die Oberflächenspannungsdifferenz zum Lack derart groß gewählt ist, dass die sich ausbildenden Radien von auf der Schlauchoberfläche sitzenden Tröpfchen größer sind als der Innendurchmesser des heraushängenden Schlauchteils. Auf diese Weise ist es verhindert, dass Lack eindringt ins Gerät.

Alternativ wird der Schlauch an seinem heraushängenden Ende geschlossen ausgeführt, beispielsweise verschweißt, und nach dem Lackieren ein Endstück abgeschnitten und somit ein Eindringen von lack während des Lackierens verhindert.

Mittels der semipermeablen Membran ist also ein Druckausgleich ermöglicht und gleichzeitig der Eintrag von Kondenswasser ins Geräteinnere verhindert. Außerdem ist mittels des Schlauchs ein Spritzwasserschutz vorsehbar, insbesondere gegen bei Reinigungsarbeiten auftretendes Spritzwasser.

Ein weiterer durch den Schlauch bewirkter Vorteil ist, dass kein Wasser an der Membran dauerhaft anstehen kann. Denn anstehendes Wasser fließt durch den Schlauch ab.

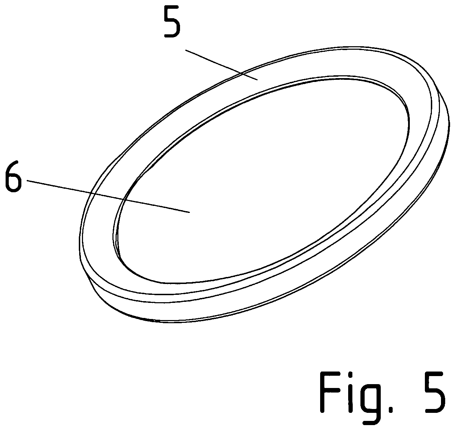

Figur 5 zeigt den Ring 5 und die in seinem Inneren angebrachte Membran 6 in Schrägansicht separat. Der Ring 5 ist kraftschlüssig im Gehäuseteil 2 verbunden. Somit ist eine einfache und schnelle Herstellung des Geräts ermöglicht.

Der Schlauch ist vorzugsweise aus einem Kunststoffmaterial auf Teflonbasis hergestellt. Beispielsweise ist ein Material wie das unter dem Handelsnamen Goretech bezeichnete verwendbar.

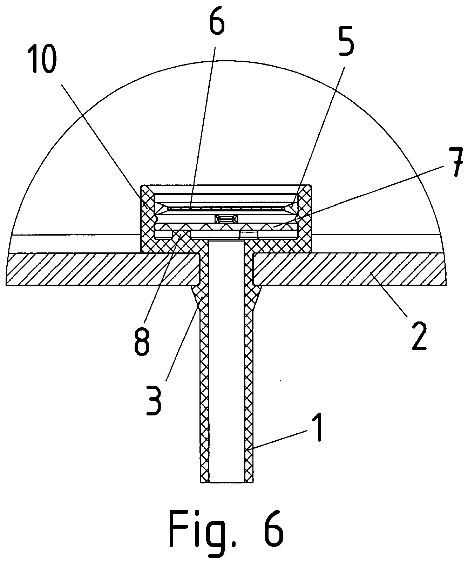

In der Figur 6 ist ein anderes erfindungsgemäßes Ausführungsbeispiel gezeigt, wobei der Schlauch einen kastenförmigen Endbereich 10 aufweist, der einerseits zusammen mit der Verdickung 3 den Schlauch in der Ausnehmung des Gehäuseteils 2 formschlüssig hält als auch andererseits zur Aufnahme des Rings 5 mit der semipermeablen Membran 6 umfasst.

Außerdem ist wiederum ein Prallschutz 7 auf Tragsäulen 8 vorgesehen, die am ins Geräteinnere weisenden Endbereich einstückig ausgeformt sind.

Als wesentlicher Unterschied zur Ausführung nach Figur 1 und Figur 3 ist keine Flachsenkung in der Gehäusewand, also in der Wandung des Gehäuseteils 2, notwendig. Somit ist also ohne Bearbeitung des Gehäuseteils der Schlauch vorsehbar. Eine einfache Bohrung in der Gehäusewand ist ausreichend. Mittels des kastenförmigen Endbereichs 10 und der Verdickung 3 ist eine dichte Verbindung des Schlauches mit dem Gehäuseteil ermöglicht. Der aus dem Gehäuseteil nach außen weisende Schlauchteil wird wiederum von Spritzwasser ausgelenkt und weist ohne Spritzwassereinwirkung in Gravitationsrichtung.

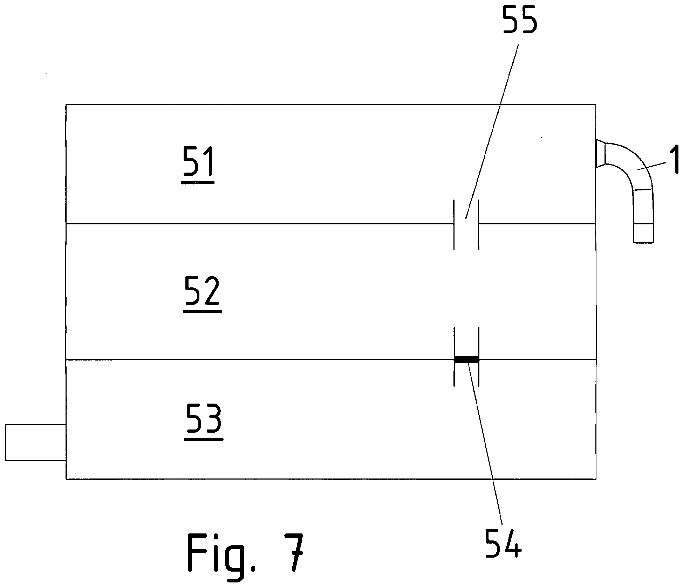

In der Figur 7 ist ein erfindungsgemäßes Ausführungsbeispiel gezeigt, wobei das Gerät einen Elektronikraumbereich 51, einen Raumbereich 52 für einen aus dem Elektronikbereich versorgten Elektromotor und einen Raumbereich 53 für ein vom Elektromotor angetriebenes, Schmierstoff, wie Schmieröl, Schmierfett oder dergleichen, umfassendes Getriebe,
wobei der Schlauch 1 zur Entlüftung des Elektronikraumbereichs vorgesehen ist,
wobei zwischen Elektronikraumbereich und Raumbereich für Elektromotor eine Öffnung 55 vorgesehen ist,
wobei zwischen Raumbereich für Elektromotor und Raumbereich für Getriebe eine schmierstoffundurchlässige elastische Membran 54 vorgesehen ist, die zum Druckausgleich zwischen Raumbereich für Elektromotor und Raumbereich für Getriebe verformbar ist in den Raumbereich des Elektromotors hinein.

Vorzugswiese ist der Schlauch 1 in den vorgenannten Ausführungen mit einer Länge zwischen 20 und 50mm ausgeführt. Besonders vorteilhaft haben sich Längen von 30 bis 40 mm erwiesen. Dabei ist eine Wandstärke zwischen 0,5 mm und 1 mm vorteilhaft. Besonders vorteilhaft haben sich Wandstärken des Schlauches von 0,6 mm bis 0,8 mm erwiesen. Als Material des Schlauches 1 ist vorzugsweise Silikon oder ein silikonhaltiger Stoff verwendet.

## Patentansprüche

1. Gerät, insbesondere ein eine elektronische Schaltung und/oder eine elektrisch bestrombare Spulenwicklung umfassendes Gerät,
**wobei** in einer Ausnehmung eines Gehäuseteils (2) des Geräts, insbesondere in einer Ausnehmung in der Gehäusewand des Geräts, ein Schlauch (1) vorgesehen ist, insbesondere ein Entlüftungsschlauch,
wobei der Schlauch (1) ein aus dem Gehäuse des Geräts herausragendes Schlauchteil umfasst,
wobei in dem ins Geräteinnere weisenden Endbereich (10) des Schlauchs (1) und/oder anschließend an das ins Geräteinnere weisende Ende des Schlauchs (1) eine Membran (6) montiert ist,
wobei die Membran (6) eine semipermeable Membran (6) ist,
**wobei** zwischen der Membran (6) und dem Schlauchteil an dem zum Innenraum des Geräts gerichteten Endbereich (10) des Schlauchs (1) ein Prallschutz (7) zum Schutz vor Wasser, das unter Druck in den Schlauch eindringt, einstückig ausgebildet ist oder separat vorgesehen und verbunden ist, wobei der Prallschutz (7) flächig ausgeformt ist und quer zur Schlauchrichtung eine den Schlauchdurchmesser überschreitende Ausdehnung aufweist und mittels Tragesäulen (8) an der Schlauchwand gehalten ist,
wobei die Membran (6) von einem Ring (5) gehalten ist,
wobei die Membran (6) auf der vom Schlauch abgewandten Seite des Prallschutzes (7) angeordnet ist,
wobei der Schlauch (1) durch Verdickungen (3) der Schlauchwand formschlüssig in der Ausnehmung des Geräts gehalten ist.

2. Gerät nach einem der vorangegangenen Ansprüche,
**dadurch gekennzeichnet, dass**
das aus dem Gehäuse des Geräts herausragende Schlauchteil aus einem derart elastischen Werkstoff ausgeführt ist, dass der herausragende Endbereich des Schlauchteils in Gravitationsrichtung ausrichtbar ist vom Eigengewicht des Schlauchteils, insbesondere von der Eigengewichtskraft des Schlauchteils, im Gravitationsfeld der Erde.

3. Gerät nach einem der vorangegangenen Ansprüche,
**dadurch gekennzeichnet, dass**
das aus dem Gehäuse des Geräts herausragende Schlauchteil aus einem derart elastischen Werkstoff ausgeführt ist und derart lang vorgesehen ist, dass der herausragende Endbereich des Schlauchteils in Gravitationsrichtung weist, insbesondere bei Ausbleiben weiterer wesentlicher Krafteinwirkungen oder Kräfte.

4. Gerät nach einem der vorangegangenen Ansprüche,
**dadurch gekennzeichnet, dass**
der Schlauch (1) aus einem derart elastischen Material vorgesehen ist und ein derart lang aus dem Gerät herausragendes Schlauchteil umfasst, dass der herausragende Endbereich des Schlauchteils in Gravitationsrichtung weist, insbesondere bei Fernbleiben sonstiger Krafteinwirkungen, oder bei einwirkenden Kräften, insbesondere verursacht durch beispielsweise Spritzwasser, Luftstrom oder dergleichen, auslenkbar ist und/oder eine Auslenkung erfährt, insbesondere in Richtung der Krafteinwirkung.

5. Gerät nach einem der vorangegangenen Ansprüche,
**dadurch gekennzeichnet, dass**
zwischen dem Schlauch (1) und dem Innenraum des Geräts eine Membran (6) vorgesehen ist.

6. Gerät nach einem der vorangegangenen Ansprüche,
**dadurch gekennzeichnet, dass**
zwischen Schlauchteil und Membran (6) ein Prallschutz (7) vorgesehen ist, insbesondere ein am Schlauch (1) einstückig ausgebildeter.

7. Gerät nach einem der vorangegangenen Ansprüche,
**dadurch gekennzeichnet, dass**
der Schlauch (1) in der Ausnehmung des Geräts formschlüssig gehalten ist.

8. Gerät nach einem der vorangegangenen Ansprüche,
**dadurch gekennzeichnet, dass**
die Wandstärke des Schlauches zwischen 0,5mm und 1 mm bei einer Länge zwischen 20 und 60 mm beträgt.

9. Gerät nach einem der vorangegangenen Ansprüche,
**dadurch gekennzeichnet, dass**
die Membran (6) mit einem Haltemittel, insbesondere Ring (5), verbunden ist.

10. Gerät nach Anspruch 9,
**dadurch gekennzeichnet, dass**
das Haltemittel mit dem Gehäuseteil (2) verbunden ist oder das Haltemittel mit dem Schlauch (1) verbunden ist, insbesondere auf der vom Schlauchteil abgewandten Seite des Prallschutzes.

11. Gerät nach einem der vorangegangenen Ansprüche,
**dadurch gekennzeichnet, dass**
der Prallschutz (7) über Haltesäulen am Schlauch (1) gehalten ist, zwischen denen in radialer Richtung durchströmbare Ausnehmungen vorgesehen sind,
**wobei Haltsäulen, Schlauch (1) und Prallschutz (7) einstückig ausgeformt sind**

12. Gerät nach Anspruch 9 oder 10,
**dadurch gekennzeichnet, dass**
das Gehäuseteil (2) eine gestufte Flachsenkung umfasst, die um die als Durchgangsbohrung ausgeführte Ausnehmung herum vorgesehen ist, insbesondere zur Aufnahme des Haltemittels für die Membran (6) und für eine den Prallschutz (7) aufnehmende Verdickung (9) des Schlauchs (1).

13. Gerät nach einem der vorangegangenen Ansprüche,
**dadurch gekennzeichnet, dass**
**eine erste der Verdickungen (3) kegelförmig ausgeführt ist, insbesondere wobei** eine zweite der Verdickungen (9) derart ausgeführt ist, dass der Prallschutz (7) von ihr umgeben ist und das Haltemittel für die Membran (6) verbindbar ist.

14. Gerät nach einem der vorangegangenen Ansprüche,
**dadurch gekennzeichnet, dass**
der Schlauch (1) an seinem nach außen weisenden Endbereich abgeschnitten ausgeführt ist.

15. Gerät nach einem der vorangegangenen Ansprüche,
**dadurch gekennzeichnet, dass**
die Einbaulage des Geräts derart gewählt ist, dass die Ausnehmung nach außen horizontal mündet oder der die Ausnehmung nach außen weist mit einem Winkel von weniger als 90° zur Gravitationsrichtung, also zur Richtung zum Schwerpunkt der Erde hin.

16. Gerät nach einem der vorangegangenen Ansprüche,
**dadurch gekennzeichnet, dass**
im Wesentlichen unabhängig von der Einbaulage des Geräts vor der Membran (6) sich befindendes Wasser abgeleitet wird durch den Schlauch (1) in die äußere Umgebung des Geräts.

17. Gerät nach einem der vorangegangenen Ansprüche,
**dadurch gekennzeichnet, dass**
das Gerät einen Elektronikraumbereich (51), einen Raumbereich (52) für einen aus dem Elektronikbereich versorgten Elektromotor und einen Raumbereich (53) für ein vom Elektromotor angetriebenes, Schmierstoff, wie Schmieröl, Schmierfett oder dergleichen, umfassendes Getriebe umfasst,
wobei der Schlauch (1) zur Entlüftung des Elektronikraumbereichs (51) vorgesehen ist, wobei zwischen Elektronikraumbereich (51) und Raumbereich (52) für Elektromotor eine Öffnung (55) vorgesehen ist,
wobei zwischen Raumbereich (52) für Elektromotor und Raumbereich (53) für Getriebe eine schmierstoffundurchlässige elastische Membran (6) vorgesehen ist, die zum Druckausgleich zwischen Raumbereich (52) für Elektromotor und Raumbereich (53) für Getriebe verformbar ist in den Raumbereich (52) des Elektromotors hinein.

18. Verfahren zur Herstellung eines Geräts nach einem der vorangegangenen Ansprüche, wobei der Schlauch vor dem Lackieren des Geräts an seinem nach außen weisenden Ende verschlossen ausgeführt ist und nach dem Lackieren der verschlossene Endbereich des Schlauchs abgeschnitten wird, insbesondere zur Erzeugung eines nach außen geöffneten herausragenden Schlauchteils,
oder das Gehäuse lackiert wird und der Schlauch aus einem derartigen Material ausgeführt ist, dass die Oberflächenspannungsdifferenz zum für das Gehäuse des Geräts gewählten Lacks derart groß gewählt ist, dass die sich ausbildenden Radien von auf der Schlauchoberfläche sitzenden Tröpfchen größer sind als der Innendurchmesser des heraushängenden Schlauchteils.

## Claims

1. A device, in particular a device comprising an electronic circuit and/or a coil winding through which electricity can flow,
wherein a hose (1), in particular a ventilation hose, is provided in a recess in a housing part (2) of the device, in particular in a recess in the housing wall of the device, wherein the hose (1) comprises a hose part projecting out of the housing of the device, wherein a membrane (6) is mounted in the end region (10) of the hose (1) which points into the interior of the device and/or adjoining the end of the hose (1) which points into the interior of the device,
wherein the membrane (6) is a semi-permeable membrane (6),
wherein an impact protection means (7) for protecting against water which penetrates into the hose under pressure is formed in one piece or is provided separately and is connected between the membrane (6) and the hose part on the end region (10) of the hose (1) which is directed towards the interior of the device,
wherein the impact protection means (7) is formed flat and transversely to the hose direction has an extent which exceeds the hose diameter and is held on the hose wall by means of supporting columns (8),
wherein the membrane (6) is held by a ring (5),
wherein the membrane (6) is arranged on the side of the impact protection means (7) remote from the hose,
wherein the hose (1) is held in the recess in the device in positive manner by thickened portions (3) of the hose wall.

2. A device according to one of the preceding claims,
**characterised in that**
the hose part which projects out of the housing of the device is made from a material which is of such elasticity that the projecting end region of the hose part can be oriented in the direction of gravity by the dead weight of the hose part, in particular by the dead weight of the hose part, in the gravitational field of the earth.

3. A device according to one of the preceding claims,
**characterised in that**
the hose part which projects out of the housing of the device is made from a material which is of such elasticity and is provided in such a length that the projecting end region of the hose part points in the direction of gravity, in particular if no further significant applications of force or forces occur.

4. A device according to one of the preceding claims,
**characterised in that**
the hose (1) is provided from a material which is of such elasticity and comprises a hose part which projects out of the device to such an extent that the projecting end region of the hose part points in the direction of gravity, in particular in the absence of other applications of force, or in the case of forces which act, in particular caused by for example splash water, air flow or the like, can be deflected and/or undergoes a deflection, in particular in the direction of the application of force.

5. A device according to one of the preceding claims,
**characterised in that**
a membrane (6) is provided between the hose (1) and the interior of the device.

6. A device according to one of the preceding claims,
**characterised in that**
an impact protection means (7) is provided between the hose part and membrane (6), in particular one which is formed in one piece on the hose (1).

7. A device according to one of the preceding claims,
**characterised in that**
the hose (1) is held in positive manner in the recess in the device.

8. A device according to one of the preceding claims,
**characterised in that**
the wall thickness of the hose is between 0.5 mm and 1 mm for a length of between 20 and 60 mm.

9. A device according to one of the preceding claims,
**characterised in that**
the membrane (6) is connected to a holding means, in particular ring (5).

10. A device according to Claim 9,
**characterised in that**
the holding means is connected to the housing part (2) or the holding means is connected to the hose (1), in particular on the side of the impact protection means remote from the hose part.

11. A device according to one of the preceding claims,
**characterised in that**
the impact protection means (7) is held on the hose (1) via holding columns, between which recesses through which a flow can pass in the radial direction are provided,
the holding columns, hose (1) and impact protection means (7) being formed of one piece.

12. A device according to Claim 9 or 10,
**characterised in that**
the housing part (2) comprises a stepped counterbore which is provided around the recess, which is in the form of a through bore, in particular for receiving the holding means for the membrane (6) and for a thickened portion (9) of the hose (1) which receives the impact protection means (7).

13. A device according to one of the preceding claims,
**characterised in that**
a first one of the thickened portions (3) is embodied conically, in particular with a second one of the thickened portions (9) being embodied such that the impact protection means (7) is surrounded thereby and the holding means for the membrane (6) can be connected.

14. A device according to one of the preceding claims,
**characterised in that**
the hose (1) is embodied cut off on its end region which points outwards.

15. A device according to one of the preceding claims,
**characterised in that**
the mounting position of the device is selected such that the recess opens horizontally outwards or [the] the recess points outwards at an angle of less than 90° to the direction of gravity, i.e. to the direction towards the centre of gravity of the earth.

16. A device according to one of the preceding claims,
**characterised in that**
substantially independently of the mounting position of the device water located in front of the membrane (6) is discharged through the hose (1) into the outer surroundings of the device.

17. A device according to one of the preceding claims,
**characterised in that**
the device has an electronics spatial region (51), a spatial region (52) for an electric motor supplied from the electronics region and a spatial region (53) for a transmission driven by the electric motor which comprises lubricant, such as lubricating oil, lubricating grease or the like,
the hose (1) being provided for venting the electronics spatial region (51),
with an opening (55) being provided between the electronics spatial region (51) and the spatial region (52) for the electric motor,
with a lubricant-impermeable elastic membrane (6) being provided between the spatial region (52) for the electric motor and the spatial region (53) for the transmission, which membrane is deformable into the spatial region (52) of the electric motor for equalising pressure between the spatial region (52) for the electric motor and the spatial region (53) for the transmission.

18. A method for producing a device according to one of the preceding claims,
wherein the hose before the device is painted is embodied closed at its end facing outwards and after painting the closed end region of the hose is cut off, in particular in order to produce a projecting hose part which is opened outwards,
or the housing is painted and the hose is made from such a material that the difference in surface tension from the paint selected for the housing of the device is selected to be so large that the radii which form of droplets located on the hose surface are greater than the internal diameter of the hose part which is hanging out.

## Revendications

1. Appareil, en particulier un appareil comprenant un circuit électronique et/ou un bobinage pouvant être alimenté électriquement,
sachant qu'un tuyau souple (1), en particulier un tuyau souple d'aération, est prévu dans un évidement d'une partie de boîtier (2) de l'appareil, en particulier dans un évidement dans la paroi du boîtier de l'appareil,
sachant que le tuyau souple (1) comprend une partie de tuyau souple faisant saillie hors du boîtier de l'appareil,
sachant qu'une membrane (6) est montée dans la région terminale (10) du tuyau souple (1) qui est dirigée à l'intérieur de l'appareil et/ou à la suite de l'extrémité du tuyau souple (1) qui est dirigée vers l'intérieur de l'appareil,
sachant que la membrane (6) est une membrane semi-perméable (6),
sachant qu'une protection déflectrice (7), destinée à protéger contre la pénétration d'eau sous pression dans le tuyau souple, est réalisée d'un seul tenant, ou prévue séparément et assemblée, sur la région terminale (10) du tuyau souple (1) qui est dirigée vers l'espace intérieur de l'appareil,
sachant que la protection déflectrice (7) est réalisée surfacique et présente transversalement à la direction du tuyau souple une étendue dépassant le diamètre du tuyau souple, et elle est maintenue sur la paroi du tuyau souple au moyen de montants porteurs (8),
sachant que la membrane (6) est maintenue par une bague (5),
sachant que la membrane (6) est disposée sur le côté de la protection déflectrice (7) qui est éloigné du tuyau souple,
sachant que le tuyau souple (1) est maintenu en engagement positif dans l'évidement de l'appareil par des épaississements (3) de la paroi du tuyau souple.

2. Appareil selon la revendication 1, **caractérisé en ce que** la partie de tuyau souple faisant saillie hors du boîtier de l'appareil est réalisée en un matériau d'une élasticité telle que la région terminale saillante de la partie de tuyau souple peut être orientée dans le sens de la pesanteur par le propre poids de la partie de tuyau souple, en particulier par la propre gravité de la partie de tuyau souple, dans le champ gravitationnel terrestre.

3. Appareil selon l'une des revendications précédentes, **caractérisé en ce que** la partie de tuyau souple faisant saillie hors du boîtier de l'appareil est réalisée en un matériau d'une élasticité telle et est prévue d'une longueur telle que la région terminale saillante de la partie de tuyau souple est dirigée dans le sens de la pesanteur, en particulier en l'absence d'autres forces ou actions de forces notables.

4. Appareil selon l'une des revendications précédentes, **caractérisé en ce que** le tuyau souple (1) est prévu en un matériau d'une élasticité telle et comprend une partie de tuyau souple faisant saillie hors de l'appareil d'une longueur telle que la région terminale saillante de la partie de tuyau souple est dirigée dans le sens de la pesanteur, en particulier en l'absence d'autres actions de forces, ou, en présence de forces agissantes, en particulier dues par exemple à des projections d'eau, un courant d'air ou analogues, peut être déviée et/ou subit une déviation, en particulier dans la direction de l'action de la force.

5. Appareil selon l'une des revendications précédentes, **caractérisé en ce qu'**une membrane (6) est prévue entre le tuyau souple (1) et l'espace intérieur de l'appareil.

6. Appareil selon l'une des revendications précédentes, **caractérisé en ce qu'**une protection déflectrice (7), en particulier réalisée d'un seul tenant sur le tuyau souple (1), est prévue entre la partie de tuyau souple et la membrane (6).

7. Appareil selon l'une des revendications précédentes, **caractérisé en ce que** le tuyau souple (1) est maintenu en engagement positif dans l'évidement de l'appareil.

8. Appareil selon l'une des revendications précédentes, **caractérisé en ce que** l'épaisseur de paroi du tuyau souple est comprise entre 0,5 mm et 1 mm pour une longueur comprise entre 20 et 60 mm.

9. Appareil selon l'une des revendications précédentes, **caractérisé en ce que** la membrane (6) est reliée à un moyen de maintien, en particulier une bague (5).

10. Appareil selon la revendication 9, **caractérisé en ce que** le moyen de maintien est relié à la partie de boîtier (2) ou le moyen de maintien est relié au tuyau souple (1), en particulier sur le côté de la protection déflectrice qui est éloigné de la partie de tuyau souple.

11. Appareil selon l'une des revendications précédentes, **caractérisé en ce que** la protection déflectrice (7) est maintenue sur le tuyau souple (1) au moyen de montants de maintien entre lesquels sont prévus des évidements pouvant être traversés par un flux en direction radiale,
sachant que les montants de maintien, le tuyau souple (1) et la protection déflectrice (7) sont façonnés d'un seul tenant.

12. Appareil selon la revendication 9 ou 10, **caractérisé en ce que** la partie de boîtier (2) comprend un alésage étagé peu profond, qui est prévu tout autour de l'évidement réalisé sous forme de perçage traversant, en particulier afin de recevoir le moyen de maintien pour la membrane (6) et pour un épaississement (9) du tuyau souple (1) recevant la protection déflectrice (7).

13. Appareil selon l'une des revendications précédentes, **caractérisé en ce qu'**un premier des épaississements (3) est réalisé conique, sachant en particulier qu'un deuxième des épaississements (9) est réalisé de telle sorte qu'il entoure la protection déflectrice (7) et que le moyen de maintien pour la membrane (6) peut être relié.

14. Appareil selon l'une des revendications précédentes, **caractérisé en ce que** le tuyau souple (1) est réalisé coupé au niveau de sa région terminale dirigée vers l'extérieur.

15. Appareil selon l'une des revendications précédentes, **caractérisé en ce que** la position d'installation de l'appareil est choisie de telle sorte que l'évidement débouche horizontalement vers l'extérieur ou que l'évidement est dirigé vers l'extérieur avec un angle inférieur à 90° par rapport au sens de la pesanteur, donc au sens allant vers le centre de gravité terrestre.

16. Appareil selon l'une des revendications précédentes, **caractérisé en ce que**, pour l'essentiel indépendamment de la position d'installation de l'appareil, l'eau qui se trouve devant la membrane (6) est évacuée par le tuyau souple (1) dans l'environnement extérieur de l'appareil.

17. Appareil selon l'une des revendications précédentes, **caractérisé en ce que** l'appareil comprend une région spatiale (51) d'équipement électronique, une région spatiale (52) pour un moteur électrique alimenté à partir de la région d'équipement électronique, et une région spatiale (53) pour une transmission entraînée par le moteur électrique et contenant un lubrifiant, tel qu'une huile lubrifiante, une graisse lubrifiante ou analogues,
sachant que le tuyau souple (1) est prévu pour l'aération de la région spatiale (51) d'équipement électronique,
sachant qu'une ouverture (55) est prévue entre la région spatiale (51) d'équipement électronique et la région spatiale (52) pour le moteur électrique,
sachant qu'une membrane élastique (6) imperméable aux lubrifiants est prévue entre la région spatiale (52) pour le moteur électrique et la région spatiale (53) pour la transmission, membrane qui, aux fins d'équilibrage de pression entre la région spatiale (52) pour le moteur électrique et la région spatiale (53) pour la transmission, est déformable à l'intérieur de la région spatiale (52) du moteur électrique.

18. Procédé de fabrication d'un appareil selon l'une des revendications précédentes,
sachant que le tuyau souple est réalisé fermé à son extrémité dirigée vers l'extérieur avant de peindre l'appareil et la région terminale fermée du tuyau souple est coupée une fois la peinture effectuée, en particulier afin de produire une partie de tuyau souple saillante ouverte vers l'extérieur,
ou que le boîtier est peint et le tuyau souple est réalisé en un matériau tel que la différence de tension superficielle par rapport à la peinture choisie pour le boîtier de l'appareil est choisie d'une grandeur telle que les rayons de gouttelettes se tenant sur la surface du tuyau souple qui se forment sont supérieurs au diamètre intérieur de la partie de tuyau souple pendant vers l'extérieur.
